Europäisches Patentamt

European Patent Office

Office européen des brevets

(11) Publication number: **0 163 409**
**A2**

## (12) EUROPEAN PATENT APPLICATION

(21) Application number: 85302765.4

(22) Date of filing: 19.04.85

(51) Int. Cl.⁴: **H 03 G 1/00**
H 03 G 3/00, H 04 M 1/60

(30) Priority: 30.05.84 GB 8413790

(43) Date of publication of application:
04.12.85 Bulletin 85/49

(84) Designated Contracting States:
AT BE CH DE FR IT LI LU NL SE

(71) Applicant: STANDARD TELEPHONES AND CABLES
PUBLIC LIMITED COMPANY
190 Strand
London, WC2R 1DU(GB)

(72) Inventor: 47 Broadleaf Avenue
Bishop's Stortford Hertfordshire
Elsenham Bishops Stortford Hertfordsire(GB)

(74) Representative: Capsey, Sydney Ross
Standard Telephones and Cables Patent Department
Edinburgh Way
Harlow Essex CM20 2SH(GB)

(54) Gain control in integrated circuits.

(57) An integrated circuit amplifier has means for external control of the gain of a signal path. A control input is coupled to an analogue to digital converter which provides stepwise control of the gain in response to a steady input control voltage.

EP 0 163 409 A2

Croydon Printing Company Ltd

## GAIN CONTROL IN INTEGRATED CIRCUITS

This invention relates to integrated circuits, e.g. for use in a telephone instrument, and in particular to gain control of said circuit.

Integrated circuits are finding increasing use in such applications as telephony. A major problem in such applications is that the various administrations require a number of different gain factors depending on the particular application to which the circuit is part. In the past this has been achieved by selection of a particular mask from a mask set in the manufacture of the circuit, or by providing a number of 'burn outs' whereby the desired gain factor can be programmed into the device. These approaches are somewhat inflexible and of course do not allow adjustment of gain by the engineer in the field. The object of the present invention is to minimise or to overcome this disadvantage.

According to the invention there is provided an integrated circuit amplifier having controllable gain of a signal path, said circuit having at least one control input, and analogue to digital converters one associated with each said input, characterised in that each said analogue to digital converter is arranged to generate a digital output signal whereby the amplifier gain is determined in response to a steady voltage input signal applied to the respective control input.

An embodiment of the invention will now be described with reference to the accompanying drawing in which:

Fig. 1 is a schematic diagram of the gain control arrangement;

and Fig. 2 shows a gain switching arrangement for use with the control signal of Figure 1.

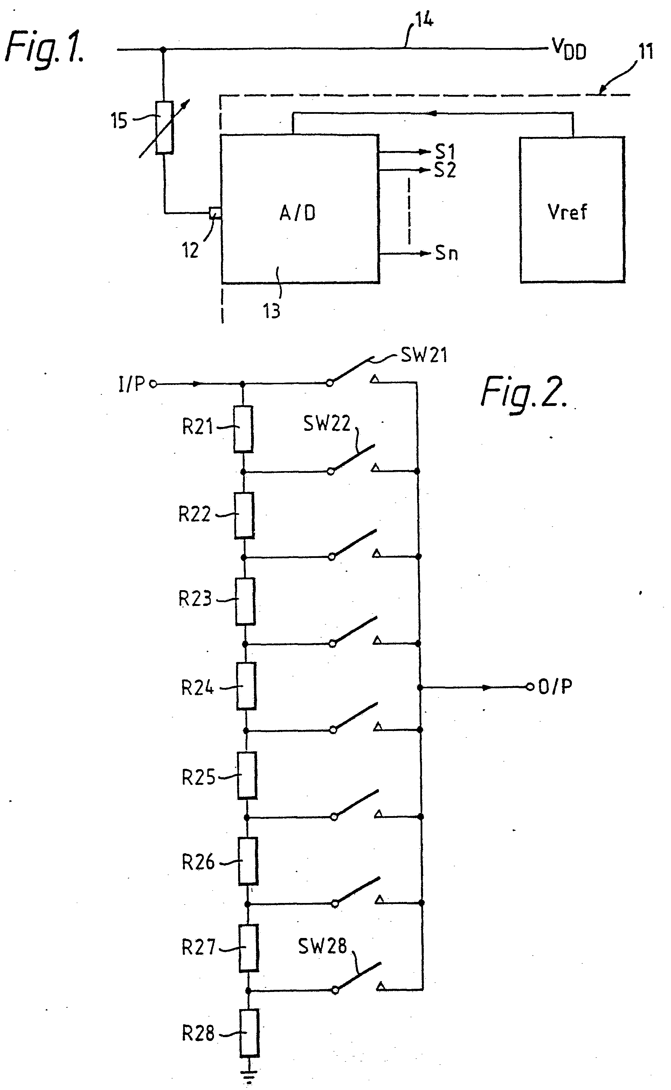

Referring to Fig. 1, the integrated circuit 11 is provided with an input pin 12 in addition to the pin count required for normal operation of the circuit. This pin 12 provides an input to an analogue to digital converter 13. The input signal is derived from the circuit $V_{DD}$ supply line 14 via a resistor 15 the value of which determines the voltage level at the pin 12.

The analogue to digital converter 13 provides a switched output dependent on the value of the resistor 14. If, for example, an eight-bit converter is employed a corresponding truth table would be as below:-

| Resistor Value/Output state (arbitrary units) | S1 | S2 | S3 | S4 | S5 | S6 | S7 | S8 |
|---|---|---|---|---|---|---|---|---|
| 1 | 1 | 0 | 0 | 0 | 0 | 0 | 0 | 0 |
| 2 | 0 | 1 | 0 | 0 | 0 | 0 | 0 | 0 |
| 4 | 0 | 0 | 1 | 0 | 0 | 0 | 0 | 0 |
| 8 | 0 | 0 | 0 | 1 | 0 | 0 | 0 | 0 |
| 16 | 0 | 0 | 0 | 0 | 1 | 0 | 0 | 0 |
| 32 | 0 | 0 | 0 | 0 | 0 | 1 | 0 | 0 |
| 64 | 0 | 0 | 0 | 0 | 0 | 0 | 1 | 0 |
| 128 | 0 | 0 | 0 | 0 | 0 | 0 | 0 | 1 |

These 1's and 0's are internal levels generated on chip and are logic ONE or logic ZERO. The logic signals are employed to switch gain levels on the chip.

A suitable gain switching technique is shown in Fig. 2. This comprises a stepwise attenuator in which the resistor values R21 to R28 depend on the ratio steps required. They may for example provide 2dB steps giving a total range of 16dB. The switches SW21 to SW28 are normal low resistance switches driven on and off from the analogue to digital converter as indicated from the truth table. A signal applied to the input I/P is attenuated by the appropriate series resistance and is then fed via the output O/P to the circuit amplifier AMP 21. Thus by providing controlled attenuation of an input signal the overall gain of the circuit may be defined.

It will be clear that the gain switching technique used in the gain control arrangement is not limited to the switched attenuator shown in Fig. 2.

The gain control arrangement described herein is particularly suitable for telephony applications. Further a plurality of such gain controls may be provided on a single chip, each with its respective input pin and analogue to digital converter, to provide, for example, independent control of transmitter gain, receiver gain and VF gain.

- 5 -                                    0163409

CLAIMS:-

1.      An integrated circuit amplifier having controllable gain of a signal path, said circuit having at least one control input, and analogue to digital converters one associated with each said input, characterised in that each said analogue to digital converter is arranged to generate a digital output signal whereby the amplifier gain is determined in response to a steady voltage input signal applied to the respective control input.

2.      An integrated circuit amplifier as claimed in claim 1, characterised in that the analogue to digital converter controls a switched attenuator in the signal path.

3.      An integrated circuit amplifier having a signal path gain controllable to any one of a plurality of preset gain levels determined via a control input, characterised in that the circuit includes an analogue to digital converter coupled to the input and having a plurality of outputs one for each said gain level, and a switched attenuator coupled to the converter output and having a plurality of impedances one for each said gain level, and that in response to an input signal, the corresponding converter output is enabled to switch the corresponding impedance into the signal path through the amplifier thereby determining the amplifier gain level.

4.      An integrated circuit amplifier as claimed in claim 1, 2 or 3, wherein said analogue to digital converter is an eight-bit converter.

5.      An integrated circuit amplifier as claimed in any one of claims 1 to 4, characterised in that the control input comprises a variable resistor whereby the gain of the circuit may be preset.

6.      A telephone instrument provided with an integrated circuit amplifier as claimed in any one of claims 1 to 5.

*Fig.1.*

*Fig.2.*